# EUROPEAN PATENT APPLICATION

(11) **EP 2 453 722 A2**
(43) Date of publication of application: **16.05.2012**
(21) Application number: 11182321.7
(22) Date of filing: 22.09.2011
(51) Int. Cl.: H05K 1/02, H05K 3/32, H05K 3/00

(54) **Electronic apparatus, method for mounting a device, and optical communication apparatus**

(30) Priority: 10.11.2010 JP 2010251909
(71) Applicant: Fujitsu Optical Components Limited, Kanagawa 211-8588 (JP)
(72) Inventor: Miyoshi, Makoto, Kanagawa, 211-8588 (JP); Ohtsu, Tsutomu, Kanagawa, 211-8588 (JP); Kezuka, Akihito, Kanagawa, 211-8588 (JP)
(74) Representative: HOFFMANN EITLE

(57) **Abstract**

An electronic apparatus includes a substrate, a device including a flange, the device being mounted at a first side of the substrate, a plate arranged at a position corresponding to the device at a second side of the substrate, the second side being opposite to the first side, and a securing member that secures the device to the substrate.

## Description

### FIELD

The embodiment disclosed herein relates to an electronic apparatus, a method for mounting a device, and an optical communication apparatus.

### BACKGROUND

The Optical Internetworking Forum (OIF) is one of the organizations that define industry standards for optical network technology. The OIF defines, for example, the properties of optical modules used in optical communication apparatuses and the interfaces of optical devices such as signal lines and pin configurations.

Optical devices handle signals of, for example, several GHz and transmit the signals over the substrate at high speed. In such optical devices, leads are formed in a straight configuration to prevent signal deterioration or loss.

Moreover, leads of the optical device are appropriately coupled to lands on the substrate by soldering. For example, each lead of the optical device is placed inside the edge of the land of the substrate for solder connection.

Thus, the leads of the optical device and the lands of the substrate are appropriately coupled by soldering, thereby meeting an interface criteria such as that defined by the OIF. In addition, Japanese Laid-open Patent Publication No. 2009-188075 discloses a printed wiring board unit and a semiconductor package that maintain a connection between the printed wiring board and the electronic circuit apparatuses without being affected by stresses.

Further, Japanese Laid-open Patent Publication No. 2002-296464 discloses an optical-electrical wiring board in which light receiving and emitting elements, such as laser diodes (LDs) and photo diodes (PDs), and electronic devices for driving those elements are all provided on a base wiring board having arrays of a plurality of ball type terminals so as to achieve a large capacity and a small-sized optical-electrical wiring board which can be assembled with high reliability.

However, such wiring boards have problems in that the connection between the leads of the optical device and the lands of the substrate may not be maintained in some cases when cracks or breaks have occurred in the solder connection between the leads of the optical device and the lands of the substrate due to warpage caused by the weight of the optical device, thermal expansion of the substrate or stress caused by an impact from the outside.

### SUMMARY

Accordingly, it is an object in one aspect of the embodiments to provide an electronic apparatus, a method for mounting a device and an optical communication apparatus that enable the connection between leads of a device and lands of a substrate to be maintained, respectively.

According to an aspect of the embodiments, an electronic apparatus includes a substrate, a device including a flange, the device being mounted at a first side of the substrate, a plate arranged at a position corresponding to the device at a second side of the substrate, the second side being opposite to the first side, and a securing member that secures the device to the substrate.

### BRIEF DESCRIPTION OF DRAWINGS

FIG. 1 is a perspective view of one example of an electronic apparatus.
FIG. 2 is a perspective view of one example of the electronic apparatus as seen from the side of a substrate opposite to that on which an optical device is mounted.
FIG. 3 is a perspective view of one example of an optical module in which the electronic apparatus is housed.
FIG. 4 is a plan view of one example of the electronic apparatus.
FIG. 5 is a side view of one example of the electronic apparatus.
FIG. 6 is a bottom view of one example of the electronic apparatus.
FIG. 7 is a perspective view of one example of the optical device.
FIG. 8 is a plan view of one example of the substrate.
FIG. 9 is a plan view of one example of a plate.
FIG. 10 is a side view of one example of the electronic apparatus that is mounted in the optical module.
FIG. 11 is a functional block diagram of one example of the electronic apparatus.
FIG. 12 is a perspective view of one example of the optical device that is secured with nuts.
FIGs. 13A and 13B show the results of impact simulation for the electronic apparatus using a plate.

### DESCRIPTION OF EMBODIMENTS

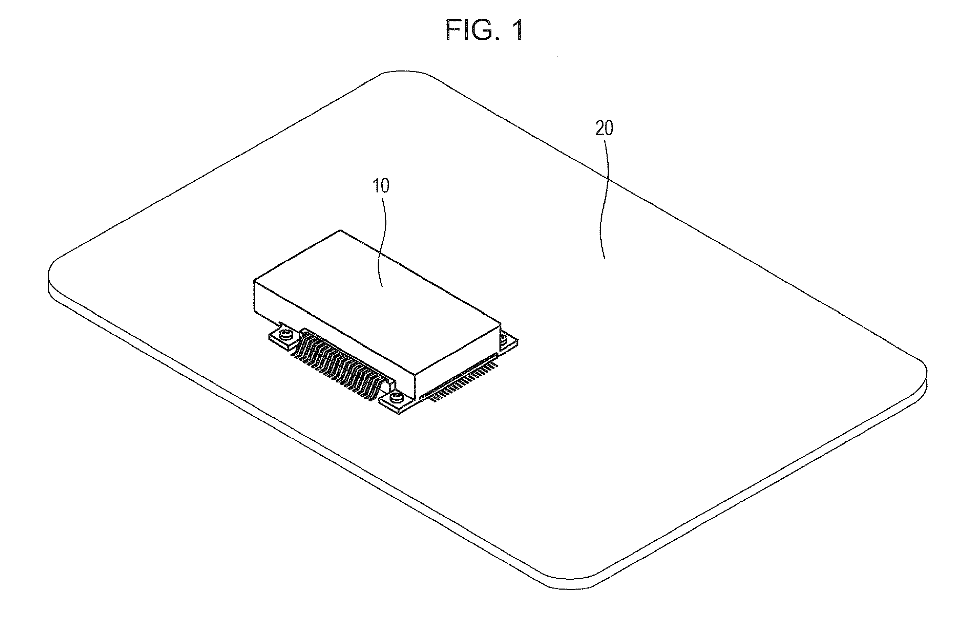

Embodiments of the invention will be described below in detail with reference to the accompanying drawings. FIG. 1 is a perspective view of one example of an electronic apparatus. As shown in FIG. 1, the electronic apparatus includes an optical device 10 and a substrate 20. The optical device 10 is, for example, an O/E (optical/electrical) converter that receives optical signals and converts the signals into electrical signals. The optical device 10 is mounted on the substrate 20 and coupled to the substrate 20 by soldering. Alternatively, the optical device 10 may be replaced by another electronic device such as a semiconductor device or a mechanism. The optical device and electronic device are collectively referred to as a device. The substrate 20 is, for example, a printed circuit board (PCB). The printed circuit board is, for example, made of an epoxy resin. Although not shown in the figure, devices other than the optical device 10 are also mounted on the substrate 20.

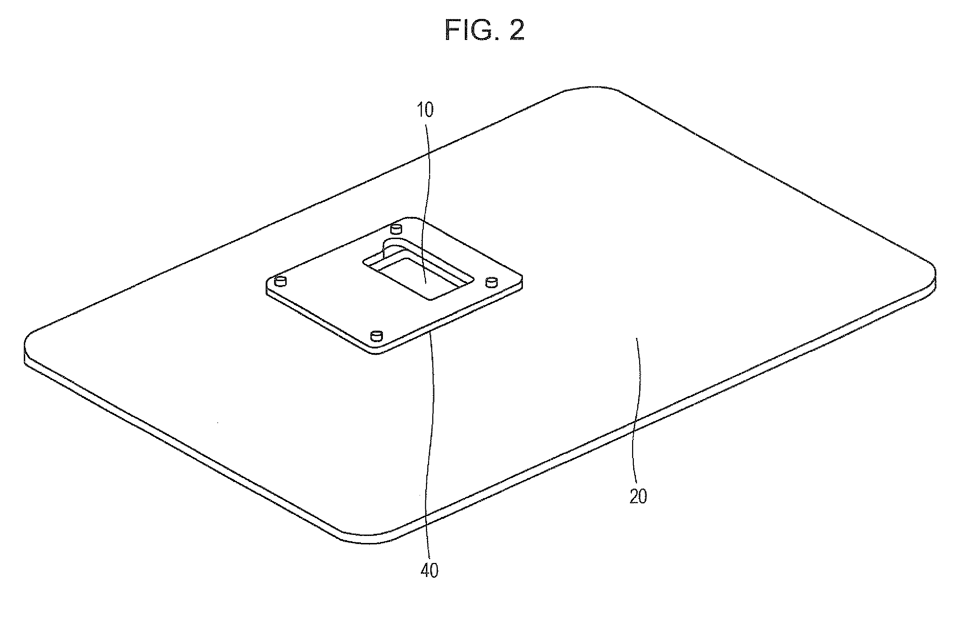

FIG. 2 is a perspective view of one example of the electronic apparatus as seen from the side of the substrate 20 opposite to that on which the optical device 10 is mounted. In FIG. 2, the same numbers refer to the same elements depicted in FIG. 1. As shown in FIG. 2, the electronic apparatus includes a plate 40. The plate 40 is disposed on the side of the substrate 20 opposite to that on which the optical device 10 is mounted at a position corresponding to the optical device 10. That is, the plate 40 is located at a position corresponding to the optical device 10 on the substrate 20. The substrate 20 and the plate 40 each have an opening at a position corresponding to the center of the optical device 10.

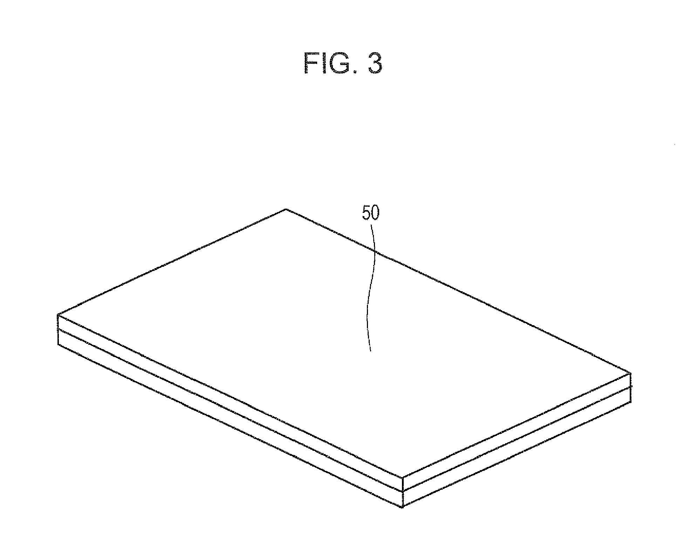

FIG. 3 is a perspective view of one example of an optical module in which the electronic apparatus is housed. FIG. 3 shows an optical module 50 in which the electronic apparatus of FIG. 1 and FIG. 2 are housed. The electronic apparatus is mounted in an optical communication apparatus, for example, as the optical module 50 and performs a specific communication function. Alternatively, the electronic apparatus may not be housed in the optical module 50 and directly mounted (not as a module) in the optical communication apparatus.

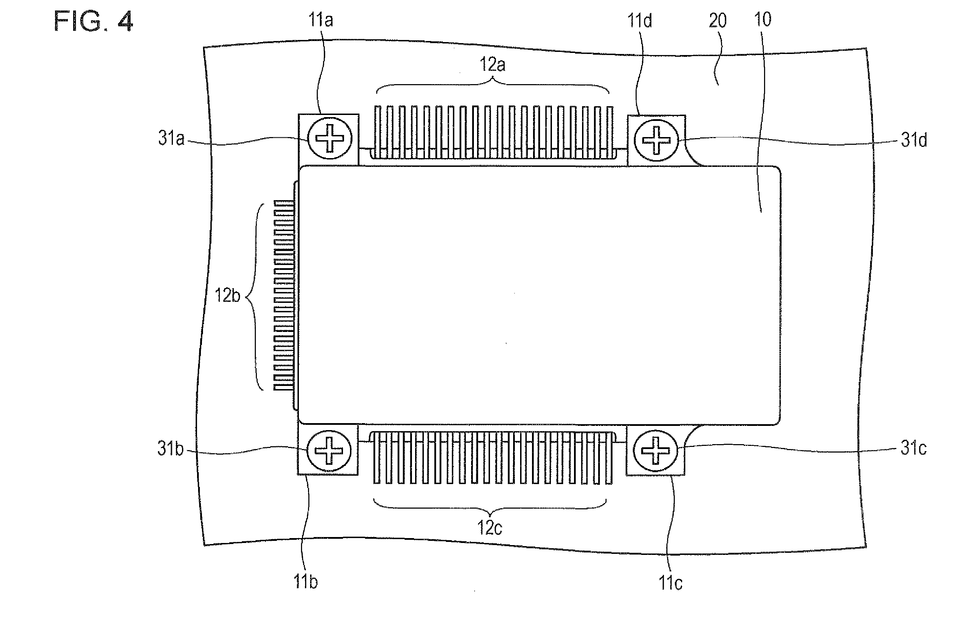

FIG. 4 is a plan view of one example of the electronic apparatus. In FIG. 4, the same numbers refer to the same elements depicted in FIG. 1 and FIG. 2. As shown in FIG. 4, the electronic apparatus includes the optical device 10, the substrate 20 and securing members 31a to 31d.

The optical device 10 has a quadrilateral shape and is provided with flanges 11a to 11d around the periphery thereof. The flanges 11a to 11d are disposed on both sides of each of leads 12a to 12c. For example, the flanges 11a and 11d are disposed on both sides of the lead 12a, the flanges 11a and 11b are disposed on both sides of the lead 12b, and the flanges 11b and 11c are disposed on both sides of the lead 12c.

The optical device 10 is provided with the leads 12a to 12c, each of which is disposed on one of the three sides of the optical device 10. The leads 12a to 12c are coupled to the lands of the substrate 20 by soldering. For example, the leads 12b are configured to be straight so as to transmit signals at a higher speed than the leads 12a and 12c. Each of the leads 12a and 12c are arranged at a pitch of, for example, approximately 1.50 mm. The leads 12b are arranged at a pitch of, for example, approximately 1.27 mm. Further, although not shown in FIG. 4, optical signals are input on the side opposite to that on which the leads 12b are disposed (on the side on which the leads 12a to 12c of the optical device 10 are not disposed).

The securing members 31a to 31d extend through the substrate 20 so as to connect the flanges 11a to 11d of the optical device 10 to the plate 40 that is provided on the opposite side of the substrate 20, which is not shown in FIG. 4, such that the optical device 10 is secured to the substrate 20. The securing members 31a to 31d are, for example, screws. Each of the screw shafts extend through the respective holes of the flanges 11a to 11d of the optical device 10 and the respective holes of the substrate 20 that are formed at positions corresponding to the holes of the flanges 11a to 11d so as to engage with the plate 40 that is provided on the opposite side of the substrate 20.

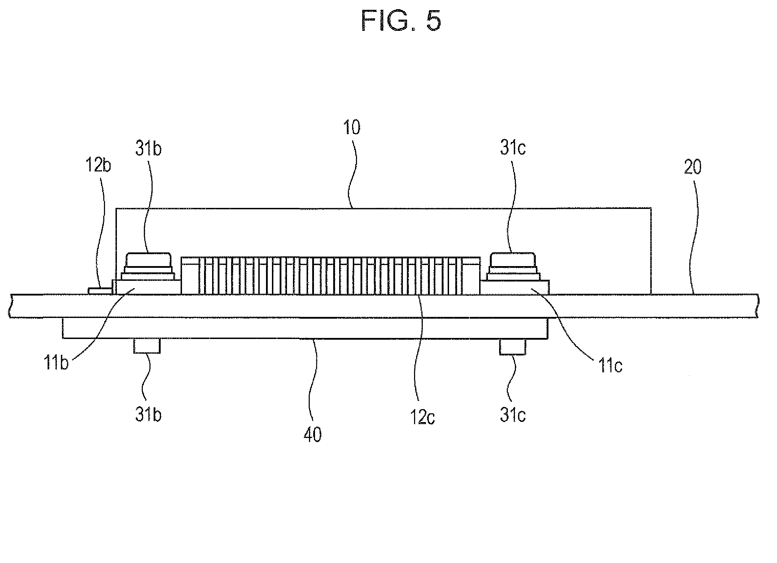

FIG. 5 is a side view of one example of the electronic apparatus. In FIG. 5, the same numbers refer to the same elements depicted in FIG. 1, FIG. 2 and FIG. 4. As shown in FIG. 5, the plate 40 is disposed on the side of the substrate 20 opposite to that on which the optical device 10 is mounted at a position corresponding to the optical device 10. The plate 40 has holes, for example, formed at positions corresponding to the flanges 11a to 11d of the optical device 10 such that the securing members 31a to 31d are fastened through the holes.

For example, in the case where the securing members 31a to 31d are screws, threaded grooves are formed inside the holes of the plate 40. The screw shafts extend through the holes of the flanges 11a to 11d and the holes of the substrate 20 and engage with the plate 40 such that the optical device 10 is secured to the substrate 20.

The plate 40, for example, has a size that overlaps the leads 12a to 12c in plan view. In addition, the plate 40 is located at a position that overlaps the leads 12a to 12c in plan view. For example, the plate 40 is located under the lead 12b shown in FIG. 5. Although not shown in FIG. 5, the plate 40 is also located under the leads 12a and 12c. The plate 40 is made of a material such as stainless steel, aluminum, brass, copper or iron. Further, for example, the plate 40 may be made of the same material as the package of the optical device 10. The thermal expansion coefficient of the plate 40 is, for example, 15±5 ppm/°C.

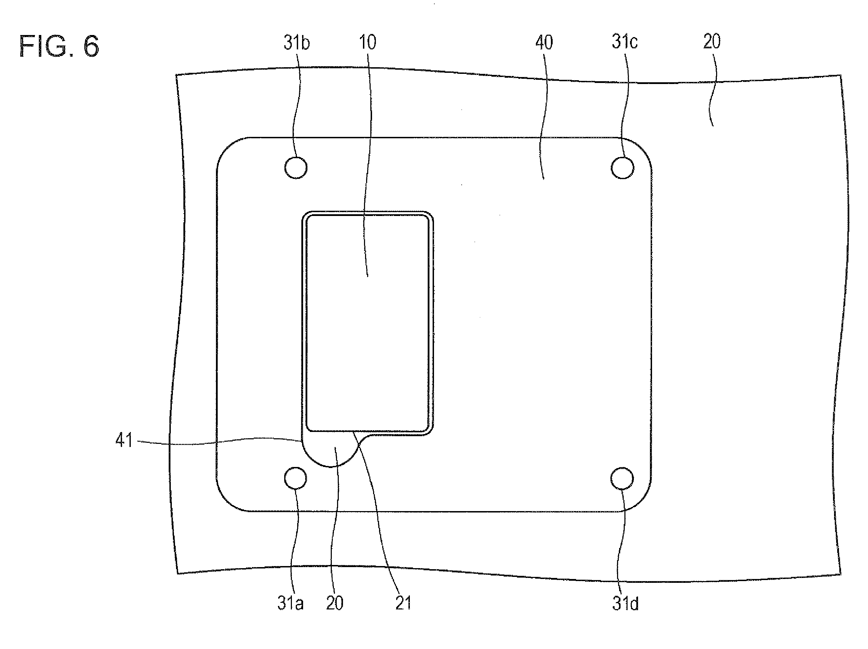

FIG. 6 is a bottom view of one example of the electronic apparatus. In FIG. 6, the same numbers refer to the same elements depicted in FIG. 1, FIG. 2, FIG. 4 and FIG. 5. As shown in FIG. 6, the substrate 20 has an opening 21 of a quadrilateral shape. The opening 21 is formed substantially in the center of the area in which the optical device 10 is secured to the substrate 20.

Further, the plate 40 has an opening 41 of a substantially quadrilateral shape. The opening 41 is formed at a position corresponding to the opening 21 when the plate 40 is secured to the substrate 20. The opening 41 has a semicircular portion so that a screw of a housing of the optical module 50 is not in contact with the plate 40 when the electronic apparatus is housed in the housing of the optical module 50. Accordingly, when the screw of the housing of the optical module 50 is not positioned in contact with the plate 40, the opening 41 of the plate 40 may be formed in a quadrilateral shape.

The electronic apparatus is fabricated by placing the optical device 10 having the flanges 11a to 11d and the plate 40 at opposing positions on both sides of the substrate 20. The flanges 11a to 11d of the optical device 10 and the plate 40 are coupled using the securing members 31a to 31d that extend through the substrate 20 such that the optical device 10 is secured to the substrate 20.

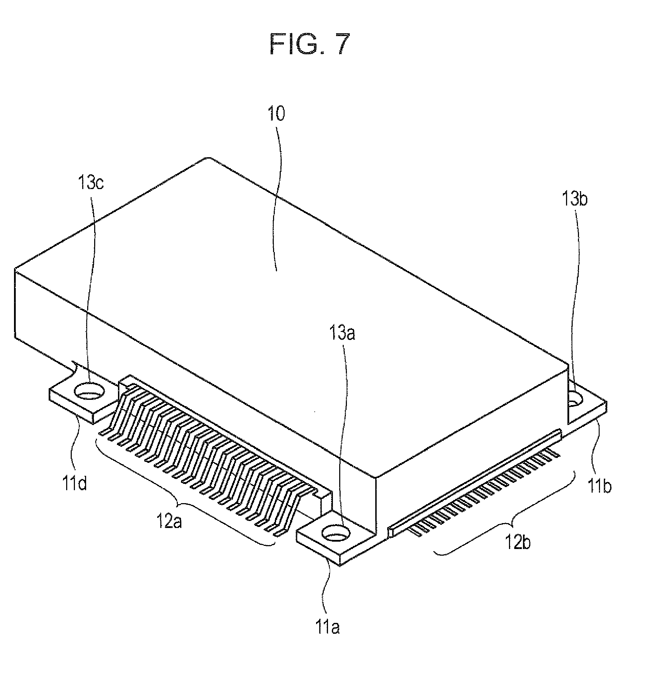

FIG. 7 is a perspective view of one example of the optical device. In FIG. 7, the same numbers refer to the same elements depicted in FIG. 1, FIG. 2 and FIG. 4 to FIG. 6. As shown in FIG. 7, the flanges 11a, 11b and 11d of the optical device 10 have the respective connecting portions 13a to 13c through which the securing members 31a, 31b and 31d are fastened. Although not shown in FIG. 7, the flange 11c of the optical device 10 has a similar connecting portion. For example, in the case where the securing members 31a to 31d are screws, the connecting portions 13a to 13c and the connecting portion not shown in the figure are formed as holes through which the shafts of the screws extend.

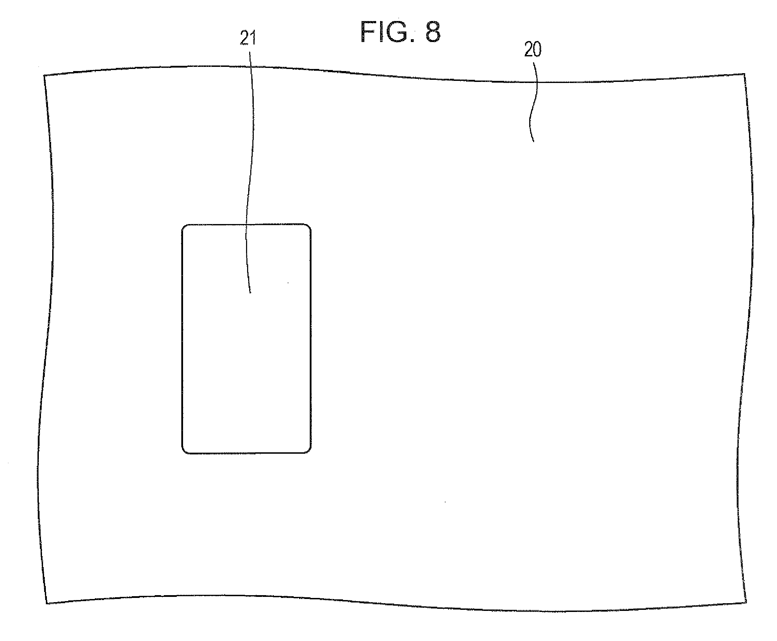

FIG. 8 is a plan view of one example of the substrate. In FIG. 8, the same numbers refer to the same elements depicted in FIG. 1, FIG. 2 and FIG. 4 to FIG. 6. As shown in FIG. 8, the substrate 20 has the opening 21. The opening 21 is formed at a position corresponding to substantially the center of the optical device 10 when the optical device 10 is secured to the substrate 20.

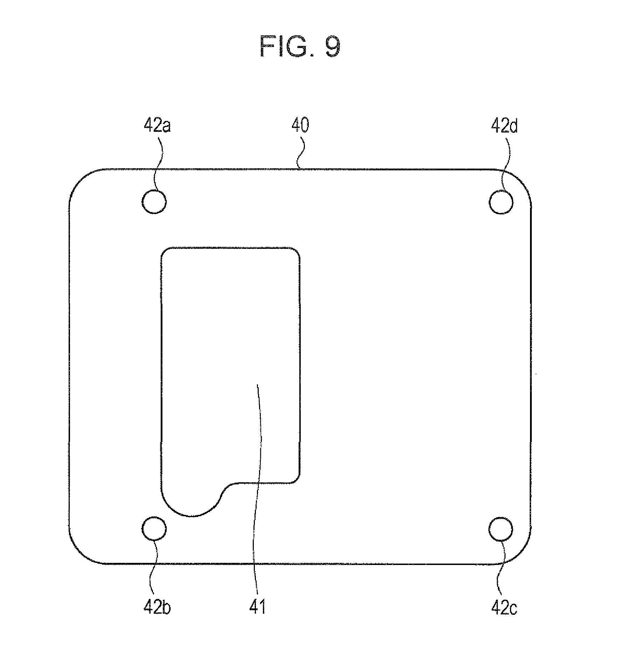

FIG. 9 is a plan view of one example of the plate. In FIG. 9, the same numbers refer to the same elements depicted in FIG. 2, FIG. 5 and FIG. 6. The plate 40 has a length in the longitudinal direction, for example, in the range of 40 mm to 50 mm and a length in the short-side direction, for example, in the range of 30 mm to 40 mm. The plate 40 has a thickness, for example, in the range of 1 mm to 3 mm. As shown in FIG. 9, the plate 40 has connecting portions 42a to 42d through which the securing members 31a to 31d are fastened. For example, in the case where the securing members 31a to 31d are screws, the connecting portions 42a to 42d are holes having threaded grooves for the screws.

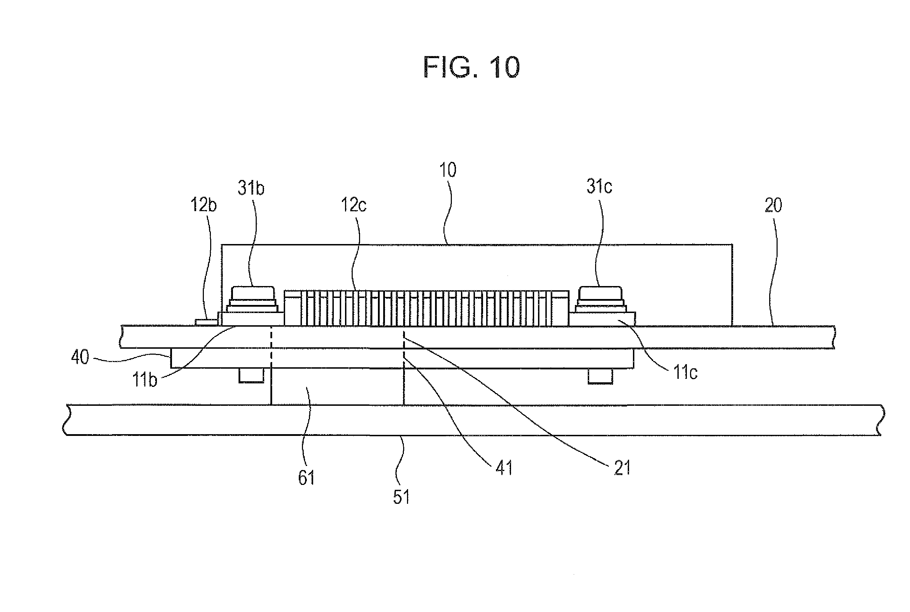

FIG. 10 is a side view of one example of the electronic apparatus that is mounted in the optical module. In FIG. 10, the same numbers refer to the same elements depicted in FIG. 4 to FIG. 8 and will not be described further. In FIG. 10, a part of a housing 51 of the optical module 50 is shown. A heat dissipating member 61 is inserted through the opening 21 of the substrate 20 and the opening 41 of the plate 40. The heat dissipating member 61 is in contact with the optical device 10 and the housing 51, thereby transferring the heat of the optical device 10 to the housing 51 of the optical module 50 so as to dissipate the heat. The heat dissipating member 61 is made of a material such as silicone, copper or silicone resin.

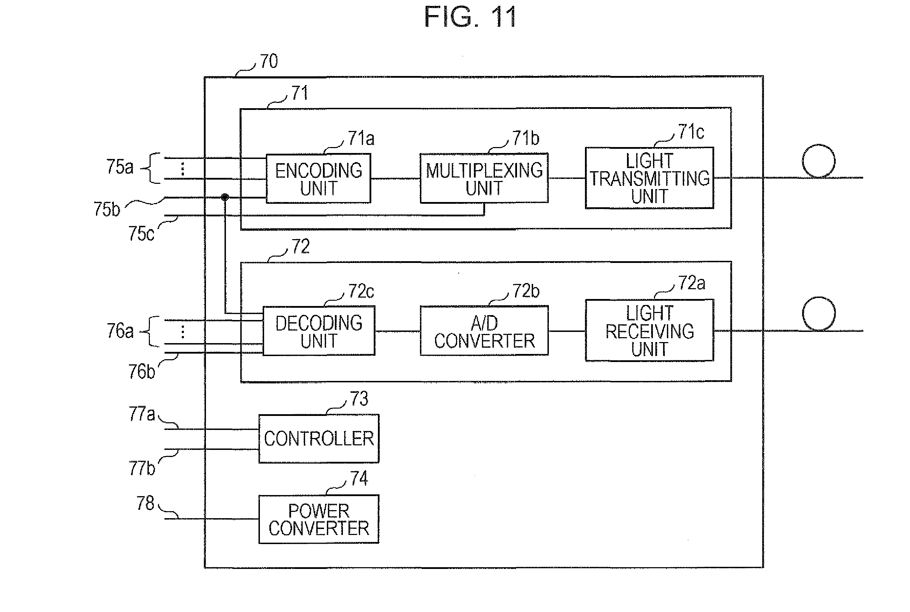

FIG. 11 is a functional block diagram of one example of the electronic apparatus. As shown in FIG. 11, the electronic apparatus 70 includes a transmitting unit 71, a receiving unit 72, a controller 73 and a power converter 74. The function of the electronic apparatus 70 shown in FIG. 11 is achieved by a plurality of devices which are mounted on the substrate 20.

The transmitting unit 71 includes an encoding unit 71a, a multiplexing unit 71b and a light transmitting unit 71c. The encoding unit 71a receives transmitter data (Tx Data) via signal lines 75a. The encoding unit 71a also receives a reference clock (REFCLK) via a signal line 75b.

The transmitter data are output from an optical communication apparatus in which the electronic apparatus 70 is mounted and optically transmitted to other optical transmission device. The transmitter data are, for example, 11 Gbit/s x 10 ch. The encoding unit 71a operates in synchronization with the reference clock and processes the received transmitter data with a forward error correction (FEC) process and an encoding process.

The multiplexing unit 71b receives the transmitter data which have been processed with the FEC process and the encoding process in the encoding unit 71a. The multiplexing unit 71b outputs a 1/16 divided frequency transmitter monitor clock (TXM CLK) in synchronization with a transmitter optical waveform via a signal line 75c. The multiplexing unit 71b multiplexes the signals which have been output from the encoding unit 71a.

The light transmitting unit 71c converts the multiplexed signals (electrical signals) which have been output from the multiplexing unit 71b into optical signals and outputs the signals to an optical fiber. A receiving unit 72 includes a light receiving unit 72a, an analog/digital (A/D) converter 72b and a decoding unit 72c.

The light receiving unit 72a receives the optical signals from the optical fiber. The light receiving unit 72a converts the input optical signals into electrical signals. The light receiving unit 72a corresponds to the optical device 10 shown in the figures such as FIG. 1 and achieves its function through the optical device 10.

The A/D converter 72b converts the electrical signals which have been converted in the light receiving unit 72a into digital signals. The decoding unit 72c receives a reference clock via the signal line 75b. The decoding unit 72c performs a decoding process and the FEC process on the digital signals in synchronization with the input reference clock and outputs receiver data (Rx Data).

The received data are output via signal lines 76a. The received data are, for example, 11 Gbit/s x 10 ch and are output to another circuit in the optical communication apparatus in which the electronic apparatus 70 is mounted.

The controller 73 controls the entire electronic apparatus 70. A device which corresponds to the controller 73 has control terminals for a management data I/O bidirectional/management data clock (MDIO/MDC). The MDIO terminal receives I/O data (data) via a signal line 77a, while the MDC terminal receives a clock via the signal line 77b in synchronization with the data input to and/or output from the MDIO terminal.

Further, a device which corresponds to the controller 73 includes a control/alarm terminal. The control/alarm terminal is a control terminal which is coupled to the signal line 77b. The power converter 74 receives, for example, a DC voltage of 12V via a power line 78. The power converter 74 converts the input DC voltage into a power-supply voltage for each device mounted in the electronic apparatus 70 and outputs the power-supply voltage.

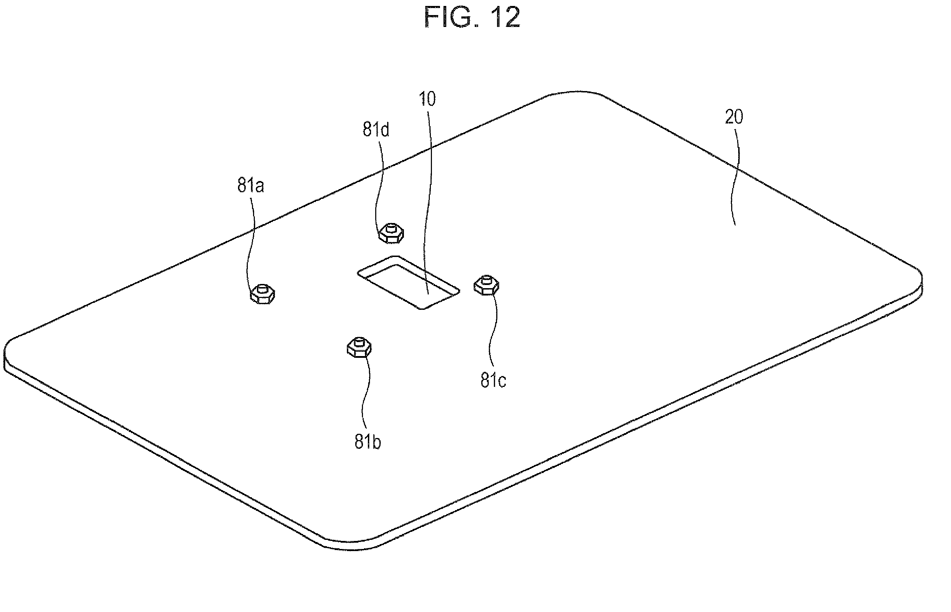

FIG. 12 is a perspective view of one example of the optical device that is secured with nuts. In the electronic apparatus shown in FIG. 12, the screw shafts extend through the holes of the flanges 11a to 11d of the optical device 10 and the holes of the substrate 20 and are fastened with nuts 81a to 81d. In the electronic apparatus of FIG. 12, cracks or breaks may occur in the solder connection between the leads of the optical device 10 and the lands of the substrate due to, for example, warpage of the substrate 20 caused by the weight of the optical device 10, a difference in thermal expansion between the optical device 10 and the substrate 20 or an impact from the outside. If cracks or breaks occur, for example, in the solder connection between the leads of the optical device 10 and the lands of the substrate, the desired property may not be achieved since the optical device 10 handles high speed signals of several GHz.

Contrary to that, in the electronic apparatus shown in the figure such as FIG. 4 to FIG. 6, the optical device 10 having the flanges 11a to 11d and the plate 40 are positioned to face each other across the substrate 20 at opposing sides of the substrate 20 with the flanges 11a to 11d and the plate 40 being coupled to each other using the securing members 31a to 31d such that the optical device 10 is secured to the substrate 20. This makes it possible to reduce the thermal stress or mechanical stress exerted on the solder connection, thereby reducing the occurrence of cracks or breaks due to warpage of the substrate 20 caused by the weight of the optical device 10, a difference in thermal expansion between the optical device 10 and the substrate 20 or an impact from the outside.

That is, in the electronic apparatus shown in the figures such as FIG. 4 to FIG. 6, the connection between the leads of the optical device 10 and the lands of the substrate can be maintained regardless of the warpage of the substrate 20, a difference in thermal expansion between the optical device 10 and the substrate 20 or an impact from the outside, thereby ensuring the desired property. For example, the property defined by the OIF can be maintained.

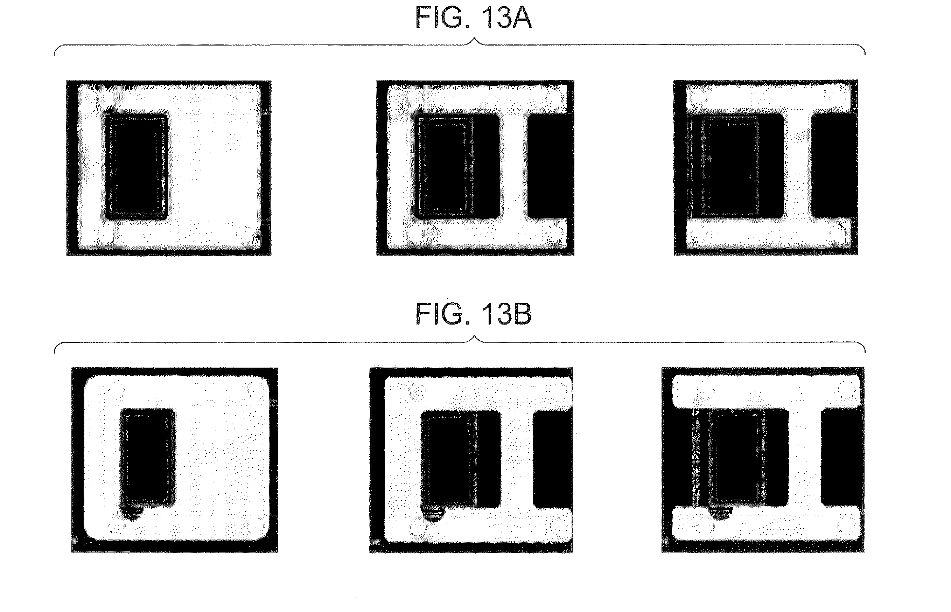

FIGs. 13A and 13B show the results of impact simulation for the electronic apparatus using a plate. FIGs. 13A and 13B show the results of impact simulation for plates such as an O-shaped plate shown in FIG. 9, an A-shaped plate and an H-shaped plate. FIG. 13A shows the results of impact simulation for the plates having a thickness of 0.8 mm, while FIG. 13B shows the results of impact simulation for the plates having a thickness of 2.0 mm. It is noted that the plates in FIG. 13A do not have a semicircular notch since the screw of the housing 51 is not in contact with the plate 40 having a thickness of 0.8 mm when the electronic apparatus is housed in the housing 51 of the optical module 50.

FIGs. 13A and 13B show the results of impact simulation for an electronic apparatus that is dropped down onto the ground while horizontally oriented as shown in FIG. 5. In FIGs. 13A and 13B, the level of force exerted on the plate is represented by the gray scale. Darker color indicates that a greater drop impact force is applied. As shown in FIGs. 13A and 13B, a maximum drop impact force is applied to the connection portion which is coupled to the securing member, and the force decreases toward the center of the plate. That is, it can be seen that the drop impact force is dispersed by the plate. Further, as can be seen from FIG. 13B, the thicker the plate is, the smaller the drop impact applied to the plate is.

As described above, in the electronic apparatus, the plate 40 is disposed on the side of the substrate 20 opposite to that on which the optical device 10 is mounted at a position corresponding to the optical device 10. Then, the securing members 31a to 31d are arranged to extend through the substrate 20 and connect the flanges 11a to 11d of the optical device 10 to the plate 40 such that the optical device 10 is secured to the substrate 20. With this configuration, it is possible to prevent cracks or breaks from occurring in the solder connection between the leads of the optical device 10 and the lands of the substrate 20, thereby maintaining the connection between the leads of the optical device 10 and the lands of the substrate 20.

Since the optical device 10 handles high speed signals, the desired property may not be achieved if cracks or breaks occur. However, the electronic apparatus can maintain the desired property by reducing the occurrence of cracks or breaks.

Further, the thermal stress or mechanical stress exerted on the solder connection can be reduced by placing and securing the plate 40 at a position that overlaps the leads of the optical device 10 in plan view, thereby effectively preventing the cracks or breaks from occurring in the solder connection between the leads of the optical device 10 and the lands of the substrate 20. The load bearing capacity of the solder connection to the cracks reduces as the lead pitch decreases. This is because the surface area of the solder connection decreases as the lead pitch decreases. According to the above-mentioned embodiment, the stress can be reduced even with a lead pitch of, for example, 1.27 mm or lower, thereby preventing the occurrence of cracks as described above.

Moreover, the heat dissipating member 61 is arranged to be in contact with the optical device 10 through the opening 21 and 41 of the substrate 20 and the plate 40, respectively, so as to dissipate the heat of the optical device 10. This makes it possible to reduce cracks or breaks caused by the thermal expansion or the like of the optical device 10.

The thermal expansion coefficients of the plate 40 and the package of the optical device 10 can be substantially equal, by using the same material for the plate 40 and the package of the optical device 10. This makes it possible for the optical device 10 and the plate 40 to deform to the same extent by thermal expansion, thereby reducing the deformation of the optical device 10 due to thermal expansion.

The plate 40 may be any other shape as long as it is shaped as a plate, and not limited to the above mentioned O-shaped, A-shaped or H-shaped plate. For example, when the heat dissipation is not required for the optical device 10, the plate without an opening may be used.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. An electronic apparatus comprising:
a substrate;
a device including a flange, the device being mounted at a first side of the substrate;
a plate arranged at a position corresponding to the device at a second side of the substrate, the second side being opposite to the first side; and
a securing member that secures the device to the substrate.

2. The electronic apparatus according to claim 1, wherein the securing member extends through the substrate from the first side to the second side and couples the flange of the device and the plate.

3. The electronic apparatus according to claim 1, wherein the plate is arranged at a position that overlaps leads of the device as viewed from a direction perpendicular to the substrate.

4. The electronic apparatus according to claim 3, wherein the device has a quadrilateral shape and includes first and second flanges arranged at a quadrilateral side of the device,
wherein a subset of the leads are arranged at the quadrilateral side between the first flange and the second flange.

5. The electronic apparatus according to claim 1, further comprising a heat dissipating member configured to dissipate the heat of the device,
wherein the heat dissipating member is arranged to be in contact with the device through an opening formed in the substrate and an opening formed in the plate.

6. The electronic apparatus according to claim 1, wherein the device and the plate are arranged to face each other across the substrate.

7. The electronic apparatus according to claim 1, wherein a thermal expansion coefficient of the plate is equal to a thermal expansion coefficient of a package of the device.

8. A method for mounting a device, comprising:
placing a device having a flange at a first side of a substrate;
placing a plate at a second side of the substrate, the second side being opposite to the first side; and
coupling the flange of the device and the plate by a securing member extending through the substrate from the first side to the second side so that the device is secured to the substrate.

9. An optical communication apparatus comprising an electronic apparatus, the electronic apparatus including:
a substrate,
a device including a flange, the device being mounted at a first side of the substrate,
a plate arranged at a position corresponding to the device at a second side of the substrate, the second side being opposite to the first side, and
a securing member that secures the device to the substrate.

10. The optical communication apparatus according to claim 10, wherein the securing member extends through the substrate from the first side to the second side and couples the flange of the device and the plate.

11. The optical communication apparatus according to claim 10, wherein the plate is arranged at a position that overlaps leads of the device as viewed from a direction perpendicular to the substrate.

12. The optical communication apparatus according to claim 11, wherein the device has a quadrilateral shape and includes first and second flanges arranged at a quadrilateral side of the device,
wherein a subset of the leads are arranged at the quadrilateral side between the first flange and the second flange.

13. The optical communication apparatus according to claim 10, further comprising a heat dissipating member configured to dissipate the heat of the device,
wherein the heat dissipating member is arranged to be in contact with the device through an opening formed in the substrate and an opening formed in the plate.

14. The optical communication apparatus according to claim 10, wherein the device and the plate are arranged to face each other across the substrate.

15. The optical communication apparatus according to claim 10, wherein a thermal expansion coefficient of the plate is equal to a thermal expansion coefficient of a package of the device.
